# EUROPEAN PATENT SPECIFICATION

(11) **EP 2 588 919 B1**
(45) Date of publication and mention of the grant of the patent: **13.04.2016**
(21) Application number: 11801304.4
(22) Date of filing: 18.05.2011
(51) Int. Cl.: G03F 7/00, B41N 1/12

(54) **METHOD OF MAKING A FLEXOGRAPHIC PRINTING PLATE COMPRISING A MULTI-LAYER COMPRESSIBLE FOAM SHEET**
VERFAHREN ZUR HERSTELLUNG EINER FLEXOGRAPHISCHEN DRUCKPLATTE MIT EINER MEHRSCHICHTIGEN KOMPRIMIERBAREN SCHAUMSCHICHT
PROCÉDÉ DE FABRICATION D'UNE PLAQUE D'IMPRESSION FLEXOGRAPHIQUE COMPRENANT UNE FEUILLE DE MOUSSE COMPRESSIBLE MULTICOUCHE

(30) Priority: 02.07.2010 US 829558
(43) Date of publication of application: 08.05.2013
(73) Proprietor: MacDermid Printing Solutions, LLC, Waterbury, Connecticut 06702 (US)
(72) Inventor: VEST, Ryan, W., Cumming GA 30041 (US)
(74) Representative: Jenkins, Peter David
(86) International application number: PCT/US2011/036943
(87) International publication number: WO 2012/003051

(56) References cited:
- EP-A1- 1 762 397
- WO-A1-00/76769
- WO-A1-2007/106489
- WO-A2-2006/135465
- US-A- 4 383 759
- US-A- 4 383 759
- US-A- 5 894 799
- US-A- 5 976 765
- US-A1- 2010 062 376
- US-B2- 7 318 994
- US-B2- 7 318 994

## Description

### FIELD OF THE INVENTION

The present invention relates generally to a multi-layer compressible foam sheet and methods of making the same for use in relief image printing plate systems.

### BACKGROUND OF THE INVENTION

Flexographic printing is widely used in the production of newspapers and in the decorative printing of packaging media. Numerous photosensitive printing plate formulations have been developed to meet the demand for fast, inexpensive processing and long press runs.

Photosensitive printing elements generally comprise a support layer, one or more photosensitive layers, an optional slip film release layer, and an optional protective cover sheet. The protective cover sheet is formed from polyethylene terephthalate or any other removable material that can protect the plate or photocurable element from damage until it is ready for use. The slip film may be disposed between the protective cover sheet and the photocurable layer(s) to protect the plate from contamination, increase ease of handling, and act as an ink-accepting layer.

Flexographic printing plates desirably work under a wide range of conditions. For example, they should be able to impart their relief image to a wide range of substrates, including cardboard, coated paper, newspaper, calendared paper, and polymeric films such as polypropylene and the like. Importantly, the image should be transferred quickly and with fidelity, for as many prints as the printer desires to make.

In a typical method of preparing a relief image printing plate, an image-bearing transparency or negative, i.e., a transparent film having opaque regions corresponding to the reverse of the image which one desires to impart to a printing plate, is placed on a glass platen, and covered with a transparent, polymeric cover film. The transparency and cover film are secured by vacuum to the platen, and a layer of photopolymerizable resin laminated to a backing sheet is placed on the cover film. Actinic radiation is shined through the glass platen toward the backing sheet. The regions of the resin which are impinged by the actinic radiation undergo polymerization or "curing" to form a cured resin that is insoluble in a solvent used for washing away uncured regions of the photopolymer to "develop" or reveal the relief image in the cured resin.

The regions of the resin layer which were protected from the actinic radiation by the opaque regions of the transparency are then washed away using a suitable developer solution. The cured regions are insoluble in the developer solution, and so after development a relief image formed of cured photopolymerizable resin is obtained. The cured resin is likewise insoluble in certain inks, and thus may be used in flexographic printing. Optionally, the liquid photopolymerizable resin may also be exposed to actinic radiation from both sides of the resin layer.

Compressible materials have found great utility in flexographic printing, particularly in the printing of corrugated stock or similar substrates that have an uneven, deformable surface. With such substrates, the printing plate must be flexible so that it will conform to the uneven surface and evenly deliver a coating of ink thereon. However, if the plate is too soft or flexible, the image on the plate will distort under the pressure used to contact the plate with the substrate, and thus will not transfer the image with the desired fidelity.

Compressible printing plates are also useful in:
A) printing on wide webs (films of cellophane, polyethylene, polypropylene, polyester, vinyl and paper having a web thickness in the range of about 12.7µm to 127µm (about 0.5 to 5 mils) to overcome sag and distortion and machine gauge variation by the compressibility of foam;
B) printing safety papers (checks, bond and stock forms) with even uniform constant tone in background print; and
C) process printing (4 color printing) where uniformity of ink laydown is critical to proper color development.

Compressible printing plates typically also have a longer life. The mechanical shock to the plate, in each print motion, can cause a gradual wearing of the relief, gradually leading to loss of sharpness in print. The compressible layer absorbs the mechanical shock leaving the relief printing surface relatively unaffected (minimal flattening or distortion) resulting in longer plate life.

Mounting a printing plate onto a compressible layer allows for the compressible layer to deform and compress with the substrate, while the printing plate can then be made to withstand the rigors of direct contact with the substrate. An alternate approach involves making the printing plate softer, which can lead to an undesirable growth of the characters under the required printing impression pressure, particularly when printing on rough or uneven stock or on presses with uneven impression and/or plate cylinders.

On their own, high durometer plates have a tendency to damage the deformable substrate during the printing process. However, a higher durometer plate, in combination with a base compressible layer, can potentially solve both of these issues. In this way, one can use a fairly hard (i.e. high durometer) plate which will not provide a distorted image, and take advantage of the compressibility of the foam backing to allow the plate to bend and flex, and thereby contact all regions of an uneven substrate. Typical compressible layers have typically consisted of foamed materials, oftentimes polyurethane or other thermoplastic materials, and can be laminated to the back of a cured image-bearing printing plate using tape or other pressure sensitive adhesive as is well known to those skilled in the art.

In most cases, the printing plate is already completely exposed and developed before the compressible layer is secured thereto, although several examples exist wherein liquid or uncured solid photopolymeric materials are cast and directly exposed on top of the compressible layer.

For example, U.S. Pat. No. 5,325,776, to Rather, Sr. et al., describes the use of polyurethane foam materials as compressible layers to be used in concert with a flexographic printing plate. However, the polyurethane foam is not UV-curable and requires a coating of an adhesive layer on top of the foam to secure the foam to the printing plate.

U.S. Pat. No. 5,894,799 to Bart et al., describes the use of an elastomeric photopolymer as the compressible layer, wherein the elastomeric photopolymer contains open cells on the surface to create the compressible nature. Photopolymerization is used only to create the open cells, and an adhesive layer is still required in the plate-laminating step. In addition, the elastomeric photopolymer of the compressible layer is a styrenic block copolymer-based photopolymer, not a polyurethane, and thus requires solvent development.

U.S. Pat. No. 5,962,111 to Rach, describes the casting of a liquid photopolymer layer onto a compressible material with open cells, and then insufficiently curing that layer to allow it to serve as a tie coat for the printing plate layer. A second coating of liquid resin is then coated on top of the pre-cured layer, and the plate is exposed and developed. In this instance, the compressible layer is required to have open cells, and is pre-treated with the resin of choice for making the printing plate. In essence, the photopolymer is serving as its own adhesive.

US 7,318,994 discloses a compressible flexographic printing plate that uses a compressible layer comprising a polyurethane(meth)acrylate resin and microspheres. WO 2006/135465 discloses a relief printing element with an integral imageable printing surface and a method of preparing the relief image printing element. EP 1,762,397 discloses a printing element with a support layer and a paint or varnish transferred printing layer, wherein there are at least two compressible layers between the carrier layer and print layer. WO 00/76769 discloses a sheet of elastomeric material that serves as a shock absorber and cushion for use between a flexographic printing plate and a printing cylinder during printing. WO 2007/106489 discloses a printing plate assembly for use in flexographic printing applications comprising an integral carrier layer, one or more cushion layers and one or more photopolymer layers.

As is readily seen, while various methods have been suggested in the prior art for preparing compressible flexographic printing plates, there remains a need in the art for preparing compressible photopolymerizable relief image plates that overcomes the shortcomings of compressible printing plates made according to prior art methodologies.

### SUMMARY OF THE INVENTION

It is an object of the present invention to provide a compressible foam sheet having multiple layers having varying thicknesses and durometers for backing a relief image printing element.

It is another object of the present invention to control the print impact of a flexographic printing plate having a compressible foam sheet backing layer.

It is still another object of the present invention to utilize a liquid photocurable microsphere containing resin system to prepare a multi-layer compressible foam sheet.

To that end, the present invention is directed to a method of making a flexographic printing plate, the method comprising the steps of:
a) casting a layer of a photocurable foam material onto a backing layer, said photocurable foam material comprising microspheres dispersed in a photocurable resin matrix;
b) curing the layer of photocurable foam material to create a first cured foam layer; and
c) repeating steps a) and b) at least once to produce at least a second cured foam layer on top of the first cured foam layer, resulting in a compressible cured multi-layer foam sheet.

Thereafter, the compressible cured multi-layer foam sheet may be laminated to a backside of a flexographic printing plate.

Also described herein is a method of making a flexographic printing plate comprising a compressible multi-layer foam sheet as a backing layer, the method comprising the steps of:
a) utilizing a dual manifold system to lay down a multi-layer photocurable foam sheet, said dual manifold system comprising at least a first manifold and a second manifold for laying down uniform layers of material, said first manifold laying down a first layer of photocurable foam material, and said second manifold laying down a second layer of photocurable foam material to create the multi-layer photocurable foam sheet;
b) overcoating the multi-layer photocurable foam sheet with a printing plate resin layer; and thereafter
c) curing the multi-layer photocurable foam sheet and the printing plate resin layer.

Also described herein is a method making a flexographic printing plate comprising a compressible multi-layer foam sheet, the method comprising the steps of:
a) providing a clear UV-curable layer;
b) casting a layer of a photocurable foam material on top of the clear UV-curable layer; and
c) overcoating the multi-layer photocurabe foam sheet with a printing plate resin layer; and thereafter
d) simultaneously curing the UV-curable layer, the layer of photocurable foam material and the printing plate resin layer.

### DETAILED DESCRIPTION OF THE PREFERRED EMBODIMENTS

The present invention is directed to an improved method of making a flexographic printing plate comprising a compressible multi-layer foam sheet, wherein each layer of the multi-layer foam sheet comprises varying thicknesses and properties.

The present invention utilizes liquid photopolymer platemaking techniques, such as capping, in combination with multiple microsphere-containing UV-curable formulations.

The novel process of the invention uses a compressible layer that may comprise a liquid polyurethane resin (preferably acrylate or methacrylate polyurethane resin) with thermoplastic microspheres dispersed therein. The microspheres serve to create voids in the urethane material, allowing for compressibility within the layer. More particularly, the present invention relates generally to a multi-layer foam construction that uses a photocurable foam material containing microspheres and utilizes liquid photopolymer platemaking techniques together with multiple microsphere containing UV-curable formulations.

In particular, in a preferred embodiment, the present invention relates generally to a method of making a multi-layer foam sheet for use as a compressible layer for a flexographic printing plate, comprising the steps of:
a) casting a layer of a photocurable foam material onto a backing layer to create a first cured foam layer, said photocurable foam material comprising microspheres dispersed in a photocurable resin matrix;
b) curing the layer of photocurable foam material to create a first cured foam layer; and
c) repeating steps a) and b) at least once to produce at least a second cured foam layer on top of the first cured foam layer, resulting in a compressible cured multi-layer foam sheet.

Thereafter, the cured multi-layer foam sheet may be laminated to a backside of a flexographic printing plate.

This first approach includes casting and curing multiple layers of varying thickness and durometer packages in order to get the desired printing impact on a liquid exposure system and laminates this separate compressible cured multi-layer foam sheet to a relief image printing plate using known adhesive means. In one embodiment, the multi-layer foam sheet may be laminated to the backside of the flexographic printing plate using an adhesive. Suitable adhesives include acrylic or rubber based adhesives. Many suitable foams are pre-coated with an adhesive layer. Double sided tape can be used, but is less preferred because its use increases the possibility of bubble formation.

The compressible cured multi-layer foam sheet typically has a thickness of 0.08 to 0.46 cm (0.03 to 0.18 inches). In particular, the first cured foam layer has a thickness of between 0.038cm and 0.36cm (0.015 in. and 0.14 in.) and the second cured foam layer has a thickness of between 0.038cm and 0.25cm (0.015 in. and 0.1 in.)

Optionally, the cured multi-layer foam sheet may comprise at least one additional cured foam layer on top of the second cured foam layer. This at least one additional cured foam layer may have a thickness of 0.008 to 0.05cm (0.003 to 0.02 inches).

In addition, the first cured foam layer typically has a durometer of 15-50 Shore A and the second cured foam layer has a durometer of 15-50 Shore A. Other durometers of the cured foam layer would also be usable in the art and would depend for example on the type of substrate being printed upon, the desired print enhancement needed and the durability of the foam.

In addition, if used, the at least one additional cured foam layer has a durometer of about 60-80 Shore A.

Another approach is to utilize a capping bucket and both manifolds of a dual manifold system to lay down a dual layer of foam prior to overcoating it with the final layer, which is the printing plate resin itself. The multilayer compressible construction can use materials of different modulus (dot gain, solid ink density) in addition to maximizing cushion life and/or enhancing press speed characteristics. The layers can also be various colors for identification purposes or to modify the imaging of the resultant printing plate resin to prevent issues with reflection of image distortion during the curing process. U.S. Patent No. 4,383,759 to Blootfhood et al. and U.S. Patent No. 5,348,605 to Hughes et al.
describe methods of using a cappling bucket and a dual manifold system during printing plate construction.

Also described herein is a method of making a flexographic printing plate comprising a compressible multi-layer foam sheet as a backing layer, the method comprising the steps of:
a) utilizing a dual manifold system to lay down a multi-layer photocurable foam sheet, said dual manifold system comprising at least a first manifold and a second manifold for laying down uniform layers of material, said first manifold laying down a first layer of photocurable foam material, and said second manifold laying down a second layer of photocurable foam material said photocurable foam material to create the multi-layer photocurable foam sheet;
b) overcoating the multi-layer photocurable foam sheet with a printing plate resin layer; and thereafter
c) curing the multi-layer photocurable foam sheet and the printing plate resin layer.

As discussed above, in one embodiment, the first photocurable resin layer and the second photocurable resin layer may have a different modulus. For example, the modulus of the first photocurable resin layer may be between 345-862 kPa (50-125 psi) and the modulus of the second photocurable resin layer is between 345-862 kPa (50-125 psi).

In another preferred embodiment, the at least one of the first photocurable layer and the second photocurable layers comprise a dye or a colorant, whereby the layers are each a different color for identification purposes or to modify the imaging of the resultant printing plate resin to substantially minimize problems associated with reflection or image distortion during the curing process.

An expansion of the multilayer concept described above is to use a sandwich approach. A clear UV curable layer on the very bottom, a thin layer of microsphere-laden compressible material, with a printing resin on top. The bottom layer serves as a higher resilience layer that would impact press rebound characteristics, while the foam layer provides cushioning for the printing element layer.

Also described herein is a method of making a flexographic printing plate having a compressible layer comprising a multi-layer foam sheet, the method comprising the steps of:
a) providing a clear UV-curable layer;
b) casting a layer of a photocurable foam material on top of the clear UV-curable layer; and
c) overcoating the layer of the photocurable foam material with a printing plate resin layer; and thereafter
d) simultaneously curing the UV-curable layer, the layer of photocurable foam material and the printing plate resin layer.

In still another embodiment of the present invention, the compressible photocurable foam layers described herein can be used with back-masking techniques to provide an imposition foam plate as well.

As discussed above, the photocurable foam layer comprises a photocurable resin matrix with microspheres dispersed therein. Optionally, but preferably the process further comprises a backmasking step after step (c) and before step (d), whereby an imposition foam plate is prepared.

The compressible multi-layer foam sheet of the present invention generally comprises a photocurable matrix comprising a liquid polyurethane resin having microspheres uniformly dispersed therein. The photocurable matrix may also contain a photoinitiator. In one embodiment, the polyurethane resin is an acrylate or methacrylate polyurethane resin.

In one embodiment, the photocurable matrix used to produce the first cured foam layer is the same as the photocurable matrix used to produce the second cured foam layer. In another embodiment, the photocurable matrix used to produce the first cured foam layer is different from the photocurable matrix used to produce the second cured foam layer.

The microspheres are preferably of uniform size and/or uniform particle distribution and can exist as either expanded or unexpanded particles. In a preferred embodiment, expanded microspheres are used, due to the heat required to effectively mix the microspheres into the viscous polyurethane methacrylate resin composition. The weight percent of the microspheres in the compressible composition typically ranges from about 0.5% to about 5.0% by weight of the resin formulation, but is preferably from about 1.0% to 2.5% by weight.

Regardless of whether the microspheres are expanded or unexpanded, the microspheres generally consist of a thermoplastic shell encapsulating a hydrocarbon. The shell of the microsphere is typically a copolymer of acrylonitrile and vinylidene chloride or methacrylonitrile, and the hydrocarbon inside the shell is typically isobutane or isopentane. There are a number of commercial sources for thermoplastic microspheres. EXPANCEL® is a trade name for microspheres available from Noble Industries. Dualite and Micropearl polymeric microspheres are available from Pierce & Stevens Corporation.

Liquid polyurethane methacrylate resins are common feedstocks for liquid photopolymer platemaking. The physical properties of the compressible multilayer foam construction can be altered through the appropriate choice of polyurethane prepolymer, together with the appropriate choice and proportion of the acrylate/methacrylate monomers. Using photoinitiators suitable for thick film imaging or high optical density imagine, i.e., a pigmented/heavily dyed system, the foam layers can be thoroughly cured under ultraviolet light to lock the microspheres into a crosslinked matrix, and also to lock in the desired physical properties of the foam. Preferably, both compressible layer(s) comprise polyurethane di(meth)acrylate resins.

The photocurable layer to which the multilayer foam sheet is laminated, adhered, or otherwise joined, generally has a thickness of 0.076 to 0.635cm (0.030 to about 0.250 inches), and is chosen for its compatibility with the compressible multilayer foam sheet such that after the curing process, the first photocurable layer and the compressible multilayer foam sheet layer remain distinct entities yet bond together tightly enough such that the layers will not separate or fracture during the printing process.

Suitable liquid photocurable materials include unsaturated polymeric compounds such as polyesters, polyethers, polyene-thiol compositions, polyurethanes, terminally unsaturated homopolymers and copolymers of butadiene, isoprene, chloroprene, styrene, isobutylene, and ethylene in which the terminal unsaturation is attached to the polymer through a combination of at least two ether, thioether, ester, keto, or amide groups, used in combination with a photoinitiator. Exemplary liquid photocurable materials are disclosed in U.S. Pat. No. 3,661,575 to Ketley et al., U.S. Pat. No. 4,332,873 to Hughes et al., and U.S. Pat. No. 4,266,007 to Hughes et al. Other liquid photocurable materials would also be known to one skilled in the art.

The liquid photopolymerizable (or photocurable) layer(s) can include any of the known photopolymers, monomers, initiators, reactive or non-reactive diluents, fillers, and dyes. The term "photocurable" refers to a solid composition which undergoes polymerization, cross-linking, or any other curing or hardening reaction in response to actinic radiation with the result that the unexposed portions of the material can be selectively separated and removed from the exposed (cured) portions to form a three-dimensional or relief pattern of cured material. Preferred photocurable materials include an elastomeric compound, an ethylenically unsaturated compound having at least one terminal ethylene group, and a photoinitiator.

The hardness of the compressible layer(s) is achieved by adjusting the composition of the layer(s) so that the layers will have the desired relative hardness after curing. This is typically accomplished by those skilled in the art by controlling the amount of cross-linking which occurs during photopolymerization. The amount of cross-linking in a polymer composition is directly proportional to its hardness. Those skilled in the art typically control the amount of cross-linking by choosing or making polymers with different degrees of unsaturation. The more unsaturation within a polymer composition, the more cross-linked the polymer will be once cured and, hence, the harder it will be. This and other methods of achieving different: degrees of hardness and other desired physical and chemical characteristics of cured photopolymer resins comprising relief image flexographic printing plates are well known to those skilled in the art and are discussed in detail in U.S. Pat. No. 4,332,873 to Hughes et al. and U.S. Pat. No. 3,990,897 to Zuerger et al. Hardness is typically measured according to the procedure set forth in ASTM standard D 2240-91 (Standard Test Method for Rubber Property-Durometer Hardness).

The photocurable compressible layers of the invention should cross-link (cure) and, thereby, harden in at least some actinic wavelength region. As used herein, actinic radiation is radiation capable of effecting a chemical change in an exposed moiety. Actinic radiation includes, for example, amplified (e.g., laser) and non-amplified light, particularly in the UV and infrared wavelength regions. Preferred actinic wavelength regions for curing the photocurable materials of the invention are from about 250 nm to about 450 nm, more preferably from about 300 nm to about 400 nm, most preferably from about 320 nm to about 380 nm. One suitable source of actinic radiation is a UV lamp, although other sources are generally known to those skilled in the art.

As discussed herein, the use of multi-layer compressible foam sheets as backing layers for a relief image printing plates allows for customization of the compressible layer, for example to impact the print result, maximize cushion life, enhance press speed characteristics and to modify the imaging of the printing plate resin. As a result, a customized compressible foam sheet can be used for backing various relief image printing plates to achieve the desired result.

While the invention has been described above with reference to specific embodiments thereof, it is apparent that many changes, modifications, and variations can be made without departing from the inventive concept disclosed here. Accordingly, it is intended to embrace all such changes, modifications, and variations that fall within the broad scope of the appended claims.

## Claims

1. A method of making a flexographic printing plate, the method comprising the steps of:
a) casting a layer of a photocurable foam material onto a backing layer, said photocurable foam material comprising microspheres dispersed in a photocurable resin matrix;
b) curing the layer of photocurable foam material to create a first cured foam layer;
c) repeating steps a) and b) at least once to produce at least a second cured foam layer on top of the first cured foam layer, resulting in a compressible cured multilayer foam sheet; and
d) attaching the compressible cured multilayer foam sheet to the back side of a flexographic printing plate.

2. The method according to claim 1, wherein the compressible cured multi-layer foam sheet has a thickness of 0.08 to 0.46cm (0.03 to 0.18 inches).

3. The method according to claim 2, wherein the first cured foam layer has a thickness of between 0.038cm and 0.36cm (0.015 in. and 0.14 in.) and the second cured foam layer has a thickness of between 0.038cm and 0.25cm (0.015 in. and 0.1 in).

4. The method according to claim 3, wherein the multi-layer foam sheet comprises at least one additional cured foam layer on top of the second cured foam layer, said at least one additional cured foam layer having a thickness of 0.008 to 0.05cm (0.003 to 0.02 inches.)

5. The method according to claim 3, wherein the first cured foam layer has a durometer of 15-50 Shore A and the second cured foam layer has a durometer of 15-50 Shore A, optionally wherein the at least one additional cured foam layer has a durometer of 60-80 Shore A.

6. The method according to claim 1, wherein the photocurable resin matrix producing the first cured foam layer is the same as the photocurable resin matrix producing the second cured foam layer.

7. The method according to claim 1, wherein the photocurable resin matrix producing the first cured foam layer is different from the photocurable resin matrix producing the second cured foam layer.

## Patentansprüche

1. Verfahren zur Herstellung einer Flexodruckplatte, wobei das Verfahren die folgenden Schritte umfasst:
a) Gießen einer Schicht aus einem lichthärtbaren Schaumstoff auf eine Trägerschicht, wobei der lichthärtbare Schaumstoff Mikrosphären umfasst, die in einer lichthärtbaren Harzmatrix verteilt sind;
b) Härten der Schicht aus dem lichthärtbaren Schaumstoff, um eine erste gehärtete Schaumschicht zu erzeugen;
c) Wiederholen der Schritte a) und b) mindestens einmal, um mindestens eine zweite gehärtete Schaumschicht auf der ersten gehärteten Schaumschicht zu produzieren, was zu einer verdichtbaren gehärteten Mehrschichtschaumplatte führt; und
d) Aufbringen der verdichtbaren gehärteten Mehrschichtschaumplatte auf die Rückseite einer Flexodruckplatte.

2. Verfahren nach Anspruch 1, wobei die verdichtbare gehärtete Mehrschichtschaumplatte eine Dicke von 0,08 bis 0,46 cm (0,03 bis 0,18 Zoll) aufweist.

3. Verfahren nach Anspruch 2, wobei die erste gehärtete Schaumschicht eine Dicke zwischen 0,038 cm und 0,36 cm (0,015 Zoll und 0,14 Zoll) aufweist und die zweite gehärtete Schaumschicht eine Dicke zwischen 0,038 cm und 0,25 cm (0,015 Zoll und 0,1 Zoll) aufweist.

4. Verfahren nach Anspruch 3, wobei die Mehrschichtschaumplatte mindestens eine zusätzliche gehärtete Schaumschicht auf der zweiten gehärteten Schaumschicht umfasst, wobei die mindestens eine zusätzliche gehärtete Schaumschicht eine Dicke von 0,008 bis 0,05 cm (0,003 bis 0,02 Zoll) aufweist.

5. Verfahren nach Anspruch 3, wobei die erste gehärtete Schaumschicht einen Durometerwert von 15-50 Shore A aufweist und die zweite gehärtete Schaumschicht einen Durometerwert von 15-50 Shore A aufweist, gegebenenfalls wobei die mindestens eine zusätzliche gehärtete Schaumschicht einen Durometerwert von 60-80 Shore A aufweist.

6. Verfahren nach Anspruch 1, wobei die lichthärtbare Harzmatrix, die die erste gehärtete Schaumschicht produziert, identisch mit der lichthärtbaren Harzmatrix ist, die die zweite gehärtete Schaumschicht produziert.

7. Verfahren nach Anspruch 1, wobei die lichthärtbare Harzmatrix, die die erste gehärtete Schaumschicht produziert, sich von der lichthärtbaren Harzmatrix unterscheidet, die die zweite gehärtete Schaumschicht produziert.

## Revendications

1. Un procédé de fabrication d'une plaque d'impression flexographique, le procédé comprenant les étapes consistant à :
a) couler une couche d'un matériau de mousse photodurcissable sur une couche de support, ledit matériau de mousse photodurcissable comprenant des microsphères dispersées dans une matrice de résine photodurcissable ;
b) durcir la couche of matériau de mousse photodurcissable pour créer une première couche de mousse durcie ;
c) répéter les étapes a) et b) au moins une fois pour produire au moins une seconde couche de mousse durcie au-dessus de la première couche de mousse durcie, ce qui résulte en une feuille de mousse multicouche durcie compressible ; et
d) attacher la feuille de mousse multicouche durcie compressible au dos d'une plaque d'impression flexographique.

2. Le procédé selon la revendication 1, dans lequel la feuille de mousse multicouche durcie compressible a une épaisseur comprise entre 0,08 et 0,46 cm (0,03 et 0,18 pouce).

3. Le procédé selon la revendication 2, dans lequel la première couche de mousse durcie a une épaisseur comprise entre 0,038 cm et 0,36 cm (0,015 pouce et 0,014 pouce) et la seconde couche de mousse durcie a une épaisseur comprise entre 0,038 cm et 0,25 cm (0,015 pouce et 0,1 pouce).

4. Le procédé selon la revendication 3, dans lequel la feuille de mousse multicouche comprend une ou plusieurs couches de mousse durcie supplémentaires au-dessus de la seconde couche de mousse durcie, ladite ou lesdites couches de mousse durcie supplémentaires ayant une épaisseur comprise entre 0,008 et 0,05 cm (0,003 et 0,02 pouce).

5. Le procédé selon la revendication 3, dans lequel la première couche de mousse durcie a une dureté au duromètre Shore A comprise entre 15 et 50 et la seconde couche de mousse durcie a une dureté au duromètre Shore A comprise entre 15 et 50, en option dans lequel la ou les couches de mousse durcie supplémentaires ont une dureté au duromètre Shore A comprise entre 60 et 80.

6. Le procédé selon la revendication 1, dans lequel la matrice de résine photodurcissable produisant la première couche de mousse durcie est la même que la matrice de résine photodurcissable produisant la seconde couche de mousse durcie.

7. Le procédé selon la revendication 1, dans lequel la matrice de résine photodurcissable produisant la première couche de mousse durcie est différente de la matrice de résine photodurcissable produisant la seconde couche de mousse durcie.
